(19) Europäisches Patentamt
European Patent Office
Office européen des brevets

(11) EP 1 998 222 B1

(12) EUROPEAN PATENT SPECIFICATION

(45) Date of publication and mention of the grant of the patent:
**20.03.2013 Bulletin 2013/12**

(51) Int Cl.:
***G03F 7/09*** *(2006.01)*

(21) Application number: **08154133.6**

(22) Date of filing: **07.04.2008**

(54) **Coating compositions**

Beschichtungszusammensetzungen

Compositions de revêtement

(84) Designated Contracting States:
**DE FR GB**

(30) Priority: **06.04.2007 US 922259 P**

(43) Date of publication of application:
**03.12.2008 Bulletin 2008/49**

(73) Proprietor: **Rohm and Haas Electronic Materials LLC**
**Marlborough, MA 01752 (US)**

(72) Inventors:
- **Gallagher, Michael K**
**Hopkington, MA 01748 (US)**
- **Zampini, Anthony**
**Westborough, MA 01581 (US)**

(74) Representative: **Buckley, Guy Julian**
**Patent Outsourcing Limited**
**1 King Street**
**Bakewell**
**Derbyshire DE45 1DZ (GB)**

(56) References cited:
**EP-A- 0 823 661**
**EP-A- 0 987 600**
**JP-A- 2002 014 474**
**US-A1- 2002 012 773**
**US-A1- 2007 042 289**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

The invention relates to organic coating compositions useful for photolithographic processes including the manufacture of semiconductors and other electronic devices. Compositions used in the invention comprise a resin component that contains nitrile moieties. The compositions are used as an underlayer material in two, three, four or more layer lithographic processes.

Photoresists are photosensitive films used for the transfer of images to a substrate. A coating layer of a photoresist is formed on a substrate and the photoresist layer is then exposed through a photomask to a source of activating radiation. The photomask has areas that are opaque to activating radiation and other areas that are transparent to activating radiation. Exposure to activating radiation provides a photoinduced or chemical transformation of the photoresist coating to thereby transfer the pattern of the photomask to the photoresist-coated substrate. Following exposure, the photoresist is developed to provide a relief image that permits selective processing of a substrate.

A major use of photoresists is in semiconductor manufacture where an object is to convert a highly polished semiconductor slice, such as silicon or gallium arsenide, into a complex matrix of electron conducting paths that perform circuit functions. Proper photoresist processing is a key to attaining this object. While there is a strong interdependency among the various photoresist processing steps, exposure is believed to be one of the most important steps in attaining high resolution photoresist images.

Reflection of activating radiation used to expose a photoresist often poses limits on resolution of the image patterned in the photoresist layer. One approach used to reduce the problem of reflected radiation has been the use of a radiation absorbing layer interposed between the substrate surface and the photoresist coating layer.

EP-A-0987600 discloses light absorbing compositions suitable for use as a bottom layer antireflective coating composition, said compositions comprising a resin binder which comprises phenyl units and, optionally, other units such as pendant cyano or itaconic anhydride groups.

EP-A-0823661 discloses a process for the formation of a resist pattern, which comprises applying an antireflective coating composition to a substrate, curing the composition and patternwise forming a photoresist layer thereon, wherein the antireflective coating composition comprises a polymer comprising hydrogen, chlorine, bromine, methyl or nitrile groups pendant to the polymer backbone. Additional groups which may be pendant to the polymer chain include hydroxyl napthyl groups.

JP-A-2002014474 discloses a pattern forming method wherein an underlayer film is prepared by dissolving a compound obtained by dehydration condensation of a napthol derivative and formaldehyde, and a resist film is formed on said underlayer film.

Electronic device manufacturers continually seek increased resolution of a photoresist image patterned over antireflective coating layers. See U.S. Patent 2004/0191479 .

We have found that current anti-reflective and under layer materials may not provide ideal performance in the lithographic process to print 45 and 32 nm features due to high 193 nm absorbance (k=0.5-0.9), high etch rates, low thermal stability and/or unacceptable levels of sublimates. Material characteristics, especially those to print 32 nm features using tri- or quad-layer in immersion processes, can be required to have one or more of the following characteristics: 193 nm optical properties in the range of n=1.5~1.85/ k=0.15~0.40, preferably in the range of n=1.65~1.75/ k=-0.24~0.32, slow oxide etch rate typical of very high carbon containing materials, fast dry etch strip rate, good planarization, compatibility with CVD Si-oxide and spin on hard mask films, low or no sublimation during high temperature (e.g. 200-250 deg. C) bake, high thermal stability (little on no weight loss at 300 deg. C and above), high modulus, and with effectively no adverse effect on film or image formed over the under layer material.

The present invention, in its various aspects, is as set out in the accompanying claims.

We now provide a coated substrate comprising new underlayer coating compositions that comprise a resin component that has nitrile substitution. Such nitrile substitution is provided by polymerization of acrylonitrile and/or methacrylonitrile.

In one embodiment, the coating composition does not comprise a resin that is fluoro-substituted, particularly a resin that has both fluoro and nitrile substitution. In a further embodiment, the coating composition does not contain a resin that has Si substitution, particularly a resin that has both Si and nitrile substitution.

In particular preferred aspects, coating compositions comprise a resin that is obtained by acrylonitrile (AN), including copolymers (i.e. two or more distinct repeat units inclusive of terpolymers, tetrapolymers, pentapolymers).

The resin of a coating composition used in the invention is a reaction product of reagents comprising acrylonitrile and/or methacrylonitrile together with hydroxy vinyl naphthalene (HVN), optionally with other reagents such as styrene. HVN can provide enhanced etch resistance to plasma etchants. Phenyl units can alone or in combine with other aromatic units such as naphthyl which may be present as hydroxynaphthyl optimize optical and other under layer characteristics that can be beneficial for high performance applications such as or 32 nm multilayer processes.

Preferably, the coating compositions used in the inventioncan be cured through thermal treatment of the composition coating layer. Suitably, the coating composition also contains an acid or more preferably an acid generator

compound, particularly a thermal acid generator compound, to facilitate the crosslinking reaction. In this aspect, preferably the composition is crosslinked prior to applying a distinct composition above the underlying layer to avoid intermixing of the distinct layers. References herein to "distinct" composition layers are intended to indicate that the composition layers are applied in distinct coating applications (particularly where one composition is treated to remove solvent carrier and/or to cause hardening (e.g. crosslinking) of composition components) and/or where the composition layers contain distinct components such as distinct resin components.

Coating compositions used in the invention are suitably and applied to a substrate as an organic solvent solution, suitably by spin-coating (i.e. a spin-on composition).

A variety of photoresists may be used in combination (i.e. overcoated) with the coating composition. Preferred photoresists for use with the underlying compositions are chemically-amplified resists, especially positive-acting photoresists that contain one or more photoacid generator compounds and a resin component that contains units that undergo a deblocking or cleavage reaction in the presence of photogenerated acid, such as photoacid-labile ester, acetal, ketal or ether units. Negative-acting photoresists also can be employed with the coating compositions, such as resists that crosslink (i.e. cure or harden) upon exposure to activating radiation. Preferred photoresists for use with a coating composition may be imaged with relatively short-wavelength radiation, e.g. radiation having a wavelength of less than 300 nm or less than 260 nm such as about 248 nm, or radiation having a wavelength of less than about 200 nm, such as 193 nm.

The invention further provides methods for forming a photoresist relief image an electronic devices as well as novel articles of manufacture comprising substrates (such as a microelectronic wafer substrate) coated with the underlying composition in combination with one or more overcoating composition layers, one or more of which overcoating is a photoresist composition.

Other aspects of the invention are disclosed infra.

As discussed above, we now provide new underlayer compositions that are used in multilayer (including dual layer, trilayer, quad-layer systems) lithographic systems. In the multilayer systems, a layer above an underlayer of the invention is a photoresist composition.

As discussed, preferred resins of coating compositions used in the invention may comprise a variety of repeat units and moieties.

For instance, monomers that may be preferably employed in copolymers of coating compositions of the invention include e.g. 3,4-epoxyhexahydrobenzyl, phenyl methyl acrylate, benzyl acrylate, cresyl acrylate, acrolein, acrolein diethyl acetal, methyl acrolein, acrylamide, acrylamide, N-methylol, Acrylamide, N-t-butyl, acrylamide, N-octadecyl, ethoxy ethyl acrylate, phenyl methyl acrylate, benzyl acrylate, ethoxy ethyl acrylate, butyl acrylate, ethyl acrylate, glycidyl acrylate, dodecyl acrylate, methyl acrylate, mono ethylene glycol acrylate, octadecyl acrylate, octyl acrylate, phenyl acrylate, methacrylate tetramethyl -4-piperidinyl, naphthyl methacrylate, dimethyl adamantyladamantyl methacrylate, benzyl methacrylate, butyl methacrylate, glycidyl methacrylate, isobutyl methacrylate, methyl methacrylate, t-butyl methacrylate, acryloyl pyrrolidone, acryloyl morpholine, acrylic acid, methacrylic acid, allyl acetate, vinylmerceptobenzothiazole, butadiene 1,4 dicarboxylate diethyl, butadiene sulfone, 4-(p-methoxyphenyl) butene, 4-phenyl butene, N-vinyl carbazole, crotonaldehyde, methoxymethyl crotonate, cyclopentene-1,3-dione, 3,3-dimethoxy cyclopropene, 3-allyl rhodanine, allyl phenyl ether, diallyl phathalate, diphenyl ethylene, hydroxyethyl methacrylate, benzyl methacrylate, methylene butyrolactone, 5-phenyl pentene, styrene, 2,3,4 trimethyl styrene, 4-methyl styrene, methoxy styrene, p-(1-(2-hysroxy butyl) styrene, p-acetoxy styrene, -methyl styrene, N,N methyl vinyl toluene sulfonamide, N-vinyl pyrrolidinone, Vinyl acetate, Vinyl benzoate, Vinyl butyl ether, Vinyl butyl sulfide, Vinyl butyl ether, Vinyl cymantrene, Vinyl dodecyl ether, Vinyl ethyl ether, Vinyl ethyl oxalate, Vinyl ethyl sulfide, Vinyl ethyl sulfoxide, Vinyl cyclohexyl ether, Vinyl isobutyl ether, Vinyl isobutyl sulfide, Vinyl octadecyl ether, Vinyl octyl ether, Vinyl phenyl ether, Vinyl phenyl sulfide, vinyl toluene sulfonamide, Vinyl phenyl ether, Vinyl p-benzyl methyl carbinol, Vinyl benzoic acid, Vinyl -t-butyl sulfide, 2-methyl-2-adamantyl methacrylate, 2-ethyl-2-adamantyl methacrylate, cyano methyl methacrylate, cyano ethyl methacrylate, , -chloro trifluoro ethyl methacrylate, trichloro ethyl methacrylate, trichloro ethyl Chloro acrylate, bromo methacrylate, Vinyl phenyl sulfide, Vinyl octadecyl ether.

Various monomers containing various crosslinking sites can also be used. Acrylate- 3,4 epoxyhexahydrobenzyl, Cresyl acrylate, Acrylamide, Acrylamide, N-methylol, Acrylamide, N-t-Butyl, glycidyl acrylate, mono ethylene glycol acrylate, ethoxy butadiene, acetoxy butadiene, diallyl phathalate, isopropenyl isocyanate, N-(p-methoxyphenyl) methacrylamide, N-(p-methoxyphenyl) methacrylamide, N-(p-methylphenyl) methacrylamide, N-(p-nitrophenyl)methacrylamide, N-phenyl methacrylamide, hydroxyethyl methacrylate, glycidyl methacrylate, p-(1-(2-hydroxy butyl) styrene, p-acetoxy styrene, butyl vinyl alcohol, vinylisocyanate.

As discussed above, the invention includes polymers that comprise nitrile groups together with hydroxy vinyl naphthalene (HVN). The HVN monomer readily polymerizes with AN to form alternating structures.

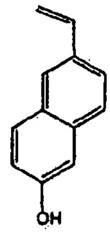

HVN

Due to the naphthalene fused ring structure, hydroxy vinyl naphthalene provides high etch resistance to the copolymer, improved thermal stability and a cross-linking site with the hydroxy group when necessary. We have further observed that the under layer film composition comprising of the AN-HVN copolymer become insoluble to resist solvents upon heating at 200-250°C for one minute. The insolubility is obtained without or with the presence of acid. Without being bound by any theory, the insolubility of the AN-co-HVN copolymer may arise from a thermal induced ring forming process. In particular, a ring forming process may lead to a polymer structure represented in Equation 4 below. Furthermore, a similar thermal ring forming process also may occur when the co-monomer is an electron rich compound such as 4-hydroxystyrene.

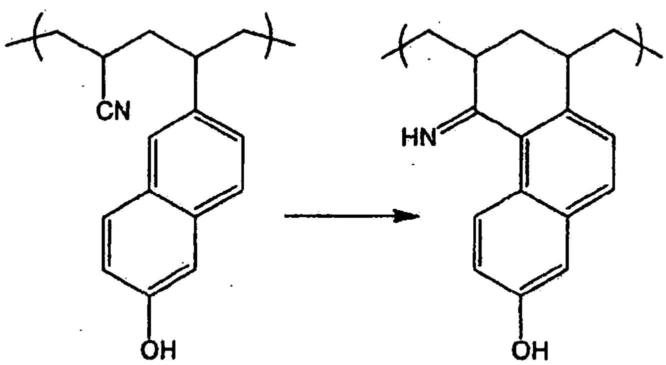

Equation 4

Other carbon rich monomers that could be used along with nitrile-containing monomers groups (e.g. AN) and HVN to further increase or modulate the etch resistance of the copolymer of the invention are: Acenaphthalene, Phenyl Acetylene, Acrylate, 3,4 epoxyhexahydrobenzyl, allyl benzene, allyl cyclohexane, vinylmerceptobenzothiazole, butadiene, 1-butene, cis-butene, trans butene, 4-cyclohexyl butene, N-vinyl carbazole, cyanocrotonate, Vinyl naphthalene, norbornadiene, norbonene, ethylidiene-2-norbornene, 5-cyclohexyl pentene, Pinene. Limonene, cyclododecatriene, camphene, Carene, dipentene vinyl caprolactum, methylene butyrolactone, styrene, 2,3,4 trimethyl styrene, 4-methyl styrene, methoxy styrene, $\alpha$-methyl styrene, tricycle dec-7-ene-,3,4,9,10 tetracarboxylic acid, Vinyl fluoride, trifluoro methyl acrylonitrile,

Underlayer compositions for certain application requiring fast etch nitrile polymers comprising of monomers such as citraconic anhydride, maleic anhydride, N-methyl citraconimide, itaconic anhydride, itaconic acid, diallyl maleate, diethyl maleate, N-octadecyl maleimide, N-(p-methoxyphenyl) methacrylamide, maleic anhydride, $\alpha$ -chloro trifluoro ethyl methacrylate, trichloro ethyl methacrylate, trichloro ethyl Chloro acrylate and bromo methacrylate can be used.

A further embodiment of the invention is AN copolymers comprising of monomer chromophore. Styrene, and similar monomers, serve as chromophore in the copolymer of the invention and also improves the etch resistance due to its high carbon content. The amount of styrene incorporated in the copolymer can be used to adjust the absorbance at 193 nm as required by the lithographic application. Chromophore monomers such as acetoxy styrene, hydroxy styrene, dihydroxy styrene, methyl hydroxy styrene, methoxy styrene, methyl styrene, halomethyl styrene, alpha-methylstyrene, alpha-methyl hydroxy and dihydroxy styrene, glycidyl ether styrene can also be used in conjunction or as substitute for styrene.

Additional monomers that may be used to impart the desired chromophoric properties are materials such as phenyl acetylene, acrylate 3,4 epoxyhexahydrobenzyl, phenyl methyl acrylate, benzyl acrylate, cresyl acrylate, phenyl methyl acrylate, benzyl acrylate, phenyl acrylate, allyl benzene, vinylmerceptobenzothiazole, 4-(p-methoxyphenyl) butene, 4-phenyl butene, allyl phenyl ether, diallyl phathalate, diphenyl ethylene, N-(p-methoxyphenyl) methacrylamide, N-(p-methoxyphenyl) methacrylamide, N-(p-methylphenyl) methacrylamide, N-(p-nitrophenyl)methacrylamide,N-phenyl methacrylamide, benzyl methacrylate, methylene butyrolactone, 5-phenyl pentene, styrene, 2,3,4 trimethyl styrene, 4-methyl styrene, methoxy styrene, , p-(1-(2-hysroxy butyl) styrene, p-acetoxy styrene, -methyl styrene, N,N methyl vinyl toluene sulfonamide, Vinyl phenyl ether, Vinyl p-benzyl methyl carbinol, Vinyl benzoic acid, Vinyl phenyl sulfide and

compounds of similar families.

A variety of additional monomer may be suitably employed to modify the film forming, etch, optical, thermal and solution properties of the under layer forming copolymer. For example 2-methylacrylonitrile can be used as a recurring unit in addition to or as a substitute of acrylonitrile, as discussed above. Additional preferred monomers that can be used in conjunction with acrylonitirle are exemplified by methacrylonitrile, vinyl dinitrile, chloro acrylonitrile, trifluoroacrylonitrile, cinnamonitrile, cyano cinnamonitrile, tetra cyano ethylene, cyanoethyl cinnamate, trifluoro methyl acrylonitrile

Recurring underlayer resin units derived from vinyl ethers such as vinyl acetate, vinyl methyl ether, vinyl alkyl ether, vinyl cycloalkyl ether, vinyl hydroxyalkyl ether, vinyl benzyl ether, vinyl aryl ether and vinyl glycidyl ether may also be used. Vinyl adamantyl ether, vinyl hydroxyadamantyl ether, vinyl ketoadamantyl ether and vinyl adamantylmethanol ether are also suitable.

Underlayer resin units that are derived from cyclic ethers also can be preferred such as furan, 2-methylfuran, dihydrofuran, dihydropyran, thiophene and pyrrole.

Additional monomers that can impart beneficial properties the copolymer of the invention are:

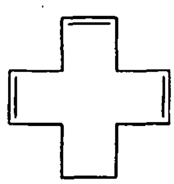
Cyclododecatriene

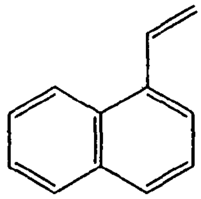
Vinyl naphthalene

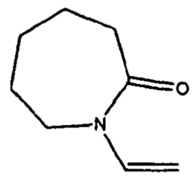
Vinyl caprolactum

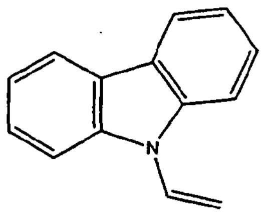
Vinyl Carbazole

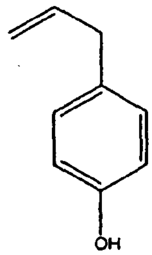
2-Allyl phenol

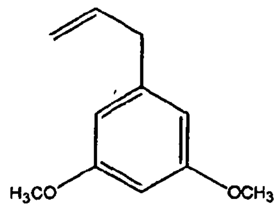
4-Allyl-2,6-dimethoxy phenol

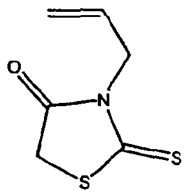
3-Allyl Rhodanine

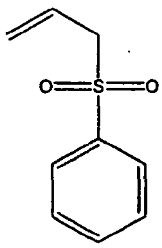
Allyl phenyl sulfone

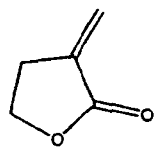
methylene butyrolactone

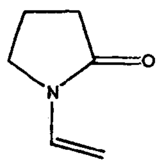
1-vinyl-2-pyrrolidinone

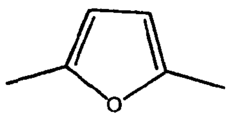

2,5-dimethyl furan

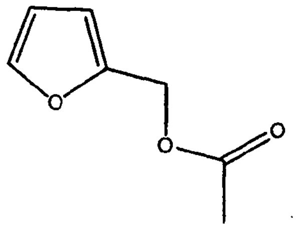

2-Furan methanol acetate

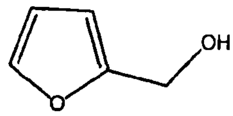

Furfuryl Alcohol

Common monomer acronyms as referred to herein include the following

| | |
|---|---|
| AN | Acrylonitrile |
| NB | Norbornene |
| AA1 | Allyl alcohol |
| VAEE | Vinyl adamantyl ethyl ether |
| Sty | Styrene |
| HVN | Hydroxy vinyl naphthalene |
| DHP | Dihydropyran |
| BV-OH | 4-Hydroxybutyl vinyl ether |
| AcSty | Acetoxystyrene |
| CHVE | Cyclohexyl vinyl ether |

Preferably resins of coating compositions will have a weight average molecular weight (Mw) of about 1,000 to about 10,000,000 daltons, more typically about 5,000 to about 1,000,000 daltons, and a number average molecular weight (Mn) of about 500 to about 1,000,000 daltons. In general, preferred resin average molecular weights may range from 2K to 60K, preferably within the 5-30K range.

Molecular weights (either Mw or Mn) of the polymers of the invention are suitably determined by gel permeation chromatography.

The concentration of a resin component of an underlying coating compositions used in the invention may vary within relatively broad ranges, and in general the resin component is employed in a concentration of from about 25 or 50 to 95 weight percent of the total of the dry components of the coating composition, more typically from about 60 to 90 weight percent of the total dry components (all components except solvent carrier).

For antireflective applications, suitably one or more of the compounds reacted to form the resin of the underlying composition (whether a nitrile-containing resin, or other resin additive of the composition) may comprise a moiety that can function as a chromophore to absorb radiation employed to expose an overcoated photoresist coating layer. For example, a phthalate compound (e.g. a phthalic acid or dialkyl phthalate (i.e. di-ester such as each ester having 1-6 carbon atoms, preferably a di-methyl or ethyl phthalate) may be polymerized with an aromatic or non-aromatic polyol and optionally other reactive compounds to provide a polyester particularly useful in a composition employed with a photoresist imaged at sub-200 nm wavelengths such as 193 nm. Similarly, resins to be used in compositions with an overcoated photoresist imaged at sub-300 nm wavelengths or sub-200 nm wavelengths such as 248 nm or 193 nm, a naphthyl compound may be polymerized, such as a naphthyl compound containing one or two or more carboxyl substituents e.g. dialkyl particularly di-C1-6alkyl naphthalenedicarboxylate. Reactive anthracene compounds also are preferred, e.g. an anthracene compound having one or more carboxy or ester groups, such as one or more methyl ester or ethyl ester groups. For imaging at 193 nm, a phenyl groups can be effective chromophores. For imaging at 248 nm, anthracene and naphthyl can be particularly effective chromophores.

As discussed above, crosslinking-type underlying coating compositions of the invention also may suitably contain a crosslinker component that is distinct from the nitrile-containing component (such as nitrile containing resin). In certain embodiments, a underlying coating composition may be cross-linking, but the composition does not contain such a separate cross-linking agent. In such embodiments, e.g., a nitrile-containing resin may have active sites for self-crosslinking reaction as may be induced thermally or otherwise.

If utilized, a variety of distinct crosslinkers may be employed, including those antireflective composition crosslinkers disclosed in Shipley European Application 542008. For example, suitable crosslinkers include amine-based crosslinkers such as melamine materials, including melamine resins such as manufactured by American Cyanamid and sold under the tradename of Cymel 300, 301, 303, 350, 370, 380, 1116 and 1130. Glycolurils are particularly preferred including glycolurils available from American Cyanamid. Benzoquanamines and urea-based materials also will be suitable

including resins such as the benzoquanamine resins available from American Cyanamid under the name Cymel 1123 and 1125, and urea resins available from American Cyanamid under the names of Beetle 60, 65, and 80. In addition to being commercially available, such amine-based resins may be prepared e.g. by the reaction of acrylamide or methacrylamide copolymers with formaldehyde in an alcohol-containing solution, or alternatively by the copolymerization of N-alkoxymethyl acrylamide or methacrylamide with other suitable monomers.

Suitable substantially neutral crosslinkers include hydroxy compounds, particularly polyfunctional compounds such as phenyl or other aromatics having one or more hydroxy or hydroxy alkyl substitutents such as a $C_{1-8}$hydroxyalkyl substitutents. Phenol compounds are generally preferred such as di-methanolphenol ($C_6H_3(CH_2OH)_2)H$) and other compounds having adjacent (within 1-2 ring atoms) hydroxy and hydroxyalkyl substitution, particularly phenyl or other aromatic compounds having one or more methanol or other hydroxylalkyl ring substituent and at least one hydroxy adjacent such hydroxyalkyl substituent.

Substantially neutral crosslinker such as a methoxy methylated glycoluril also may be preferred.

If employed, a separate crosslinker component of an underlying composition invention may be present in an amount of between about 5 and 50 weight percent of total solids (all components except solvent carrier) of the underlying composition, more typically in an amount of about 7 to 25 weight percent total solids.

As mentioned, preferred underlying coating compositions used in the invention can be crosslinked, e.g. by thermal and/or radiation treatment. For example, as discussed, preferred underlying coating compositions may contain a separate crosslinker component that can crosslink with one or more other components of the underlying composition. Generally preferred crosslinking underlying compositions comprise a separate crosslinker component. Particularly preferred underlying compositions contain as separate components: a nitrile-containing resin, a crosslinker, and an acid or thermal acid generator compound. Crosslinking underlying compositions are preferably crosslinked prior to application of an overcoating composition layer such as a photoresist layer. Thermal-induced crosslinking of the underlying composition that includes activation (i.e. acid generation) of the thermal acid generator is generally preferred.

If a thermal acid generator is utilized, underlying coating compositions may comprise an ionic or substantially neutral thermal acid generator, e.g. an ammonium arenesulfonate salt, for catalyzing or promoting crosslinking during curing of an the underlying composition coating layer. Typically one or more thermal acid generators are present in an underlying composition in a concentration from about 0.1 to 10 percent by weight of the total of the dry components of the composition (all components except solvent carrier), more preferably about 2 percent by weight of the total dry components.

Coating compositions used in the invention also may optionally contain one or more photoacid generator compounds typically in addition to another acid source such as an acid or thermal acid generator compound. In such use of a photoacid generator compound (PAG), the photoacid generator is not used as an acid source for promoting a crosslinking reaction, and thus preferably the photoacid generator is not substantially activated during crosslinking of the coating composition (in the case of a crosslinking coating composition). Such use of photoacid generators is disclosed in U.S. Patent 6,261,743 assigned to the Shipley Company. In particular, with respect to coating compositions that are thermally crosslinked, the coating composition PAG should be substantially stable to the conditions of the crosslinking reaction so that the PAG can be activated and generate acid during subsequent exposure of an overcoated resist layer. Specifically, preferred PAGs do not substantially decompose or otherwise degrade upon exposure of temperatures of from about 140 or 150 to 190° C for 5 to 30 or more minutes.

Generally preferred photoacid generators for such use in underlying composition of the invention include e.g. onium salts such as di(4-tert-butylphenyl)iodonium perfluoroctane sulphonate, halogenated non-ionic photoacid generators such as 1,1-bis[p-chlorophenyl]-2,2,2-trichloroethane, and other photoacid generators disclosed for use in photoresist compositions.

*Formulation ofan underlying coating composition*

To make a liquid underlying coating composition used in the invention, the components of the underlying coating composition are dissolved in a suitable solvent such as, for example, one or more oxyisobutyric acid esters particularly methyl-2-hydroxyisobutyrate as discussed above, ethyl lactate or one or more of the glycol ethers such as 2-methoxyethyl ether (diglyme), ethylene glycol monomethyl ether, and propylene glycol monomethyl ether; solvents that have both ether and hydroxy moieties such as methoxy butanol, ethoxy butanol, methoxy propanol, and ethoxy propanol; esters such as methyl cellosolve acetate, ethyl cellosolve acetate, propylene glycol monomethyl ether acetate, dipropylene glycol monomethyl ether acetate and other solvents such as dibasic esters, propylene carbonate and gamma-butyro lactone. A preferred solvent for an underlying coating composition used in the invention is methyl-2-hydroxyisobutyrate, optionally blended with anisole. The concentration of the dry components in the solvent will depend on several factors such as the method of application. In general, the solids content of an underlying composition varies from about 0.5 to 20 weight percent of the total weight of the coating composition, preferably the solids content varies from about 2 to 10 weight of the coating composition.

*Exemplary photoresist systems*

A variety of photoresist compositions can be employed with the coating compositions, including positive-acting and negative-acting photoacid-generating compositions. Photoresists used with the underlying compositions typically comprise a resin binder and a photoactive component, typically a photoacid generator compound. Preferably the photoresist resin binder has functional groups that impart alkaline aqueous developability to the imaged resist composition.

Particularly preferred photoresists for use with the underlying compositions are chemically-amplified resists, particularly positive-acting chemically-amplified resist compositions, where the photoactivated acid in the resist layer induces a deprotection-type reaction of one or more composition components to thereby provide solubility differentials between exposed and unexposed regions of the resist coating layer. A number of chemically-amplified resist compositions have been described, e.g., in U.S. Pat. Nos. 4,968,581 ; 4,883,740 ; 4,810,613 ; 4,491,628 and 5,492,793. Coating compositions of the invention are particularly suitably used with positive chemically-amplified photoresists that have acetal groups that undergo deblocking in the presence of a photoacid. Such acetal-based resists have been described in e.g. U.S. Patents 5,929,176 and 6,090,526 .

The underlying compositions also may be used with other positive resists, including those that contain resin binders that comprise polar functional groups such as hydroxyl or carboxylate and the resin binder is used in a resist composition in an amount sufficient to render the resist developable with an aqueous alkaline solution. Generally preferred resist resin binders are phenolic resins including phenol aldehyde condensates known in the art as novolak resins, homo and copolymers or alkenyl phenols and homo and copolymers of N-hydroxyphenyl-maleimides.

Preferred positive-acting photoresists for use with the underlying coating composition contain an imaging-effective amount of photoacid generator compounds and one or more resins that are selected from the group of:

1) a phenolic resin that contains acid-labile groups that can provide a chemically amplified positive resist particularly suitable for imaging at 248 nm. Particularly preferred resins of this class include: i) polymers that contain polymerized units of a vinyl phenol and an alkyl acrylate, where the polymerized alkyl acrylate units can undergo a deblocking reaction in the presence of photoacid. Exemplary alkyl acrylates that can undergo a photoacid-induced deblocking reaction include e.g. t-butyl acrylate, t-butyl methacrylate, methyladamantyl acrylate, methyl adamantyl methacrylate, and other non-cyclic alkyl and alicyclic acrylates that can undergo a photoacid-induced reaction, such as polymers in U.S. Patents 6,042,997 and 5,492,793; ii) polymers that contain polymerized units of a vinyl phenol, an optionally substituted vinyl phenyl (e.g. styrene) that does not contain a hydroxy or carboxy ring substituent, and an alkyl acrylate such as those deblocking groups described with polymers i) above, such as polymers described in U.S. Patent 6,042,997; and iii) polymers that contain repeat units that comprise an acetal or ketal moiety that will react with photoacid, and optionally aromatic repeat units such as phenyl or phenolic groups; such polymers have been described in U.S. Patents 5,929,176 and 6,090,526.

2) a resin that is substantially or completely free of phenyl or other aromatic groups that can provide a chemically amplified positive resist particularly suitable for imaging at sub-200 nm wavelengths such as 193 nm. Particularly preferred resins of this class include: i) polymers that contain polymerized units of a non-aromatic cyclic olefin (endocyclic double bond) such as an optionally substituted norbornene, such as polymers described in U.S. Patents 5,843,624, and 6,048,664; ii) polymers that contain alkyl acrylate units such as e.g. t-butyl acrylate, t-butyl methacrylate, methyladamantyl acrylate, methyl adamantyl methacrylate, and other non-cyclic alkyl and alicyclic acrylates; such polymers have been described in U.S. Patent 6,057,083; European Published Applications EP01008913A1 and EP00930542A1; and U.S. pending Patent Application No. 09/143,462 and iii) polymers that contain polymerized anhydride units, particularly polymerized maleic anhydride and/or itaconic anhydride units, such as disclosed in European Published Application EP01008913A1 and U.S. Patent 6,048,662.

3) a resin that contains repeat units that contain a hetero atom, particularly oxygen and/or sulfur (but other than an anhydride, i.e. the unit does not contain a keto ring atom), and preferable are substantially or completely free of any aromatic units. Preferably, the heteroalicyclic unit is fused to the resin backbone, and further preferred is where the resin comprises a fused carbon alicyclic unit such as provided by polymerization of a norborene group and/or an anhydride unit such as provided by polymerization of a maleic anhydride or itaconic anhydride. Such resins are disclosed in PCT/US01/14914 and U.S. application number 09/567,634.

4) a resin that contains fluorine substitution (fluoropolymer), e.g. as may be provided by polymerization of tetrafluoroethylene, a fluorinated aromatic group such as fluoro-styrene compound, and the like. Examples of such resins are disclosed e.g. in PCT/US99/21912.

Suitable photoacid generators to employ in a positive or negative acting photoresist overcoated over a coating composition of the invention include imidosulfonates such as compounds of the following formula:

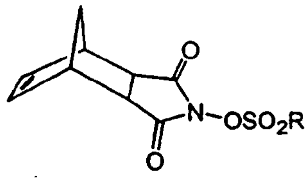

wherein R is camphor, adamantane, alkyl (e.g. $C_{1-12}$ alkyl) and perfluoroalkyl such as perfluoro($C_{1-12}$alkyl), particularly perfluorooctanesulfonate, perfluorononanesulfonate and the like. A specifically preferred PAG is N-[(perfluorooctanesulfonyl)oxy]-5-norbomene-2,3-dicarboximide.

Sulfonate compounds are also suitable PAGs for resists overcoated a coating composition of the invention , particularly sulfonate salts. Two suitable agents for 193 nm and 248 nm imaging are the following PAGS 1 and 2:

1

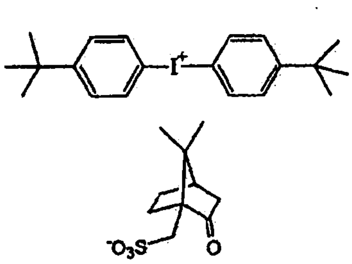

2

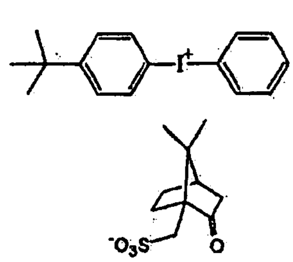

Such sulfonate compounds can be prepared as disclosed in European Patent Application 96118111.2 (publication number 0783136), which details the synthesis of above PAG 1.

Also suitable are the above two iodonium compounds complexed with anions other than the above-depicted camphorsulfonate groups. In particular, preferred anions include those of the formula $RSO_3$- where R is adamantane, alkyl (e.g. C1-12 alkyl) and perfluoroalkyl such as perfluoro (C1-12alkyl), particularly perfluorooctanesulfonate, perfluorobutanesulfonate and the like.

Other known PAGS also may be employed in photoresist used with underlying coating compositions.

A preferred optional additive of photoresist compositions used in the invention is an added base, particularly tetrabutylammonium hydroxide (TBAH), or tetrabutylammonium lactate, which can enhance resolution of a developed resist relief image. For resists imaged at 193 nm, a preferred added base is a hindered amine such as diazabicyclo undecene or diazabicyclononene. The added base is suitably used in relatively small amounts, e.g. about 0.03 to 5 percent by weight relative to the total solids.

Preferred negative-acting resist compositions for use with an overcoated coating composition used in the invention comprise a mixture of materials that will cure, crosslink or harden upon exposure to acid, and a photoacid generator.

Particularly preferred negative-acting resist compositions comprise a resin binder such as a phenolic resin, a crosslinker component and a photoactive component of the invention. Such compositions and the use thereof have been disclosed in European Patent Applications 0164248 and 0232972 and in U.S. Pat. No. 5,128,232 to Thackeray et al. Preferred phenolic resins for use as the resin binder component include novolaks and poly(vinylphenol)s such as those discussed above. Preferred crosslinkers include amine-based materials, including melamine, glycolurils, benzoguanamine-based materials and urea-based materials. Melamine-formaldehyde resins are generally most preferred. Such crosslinkers are commercially available, e.g. the melamine resins sold by Cytec Industries under the trade names Cymel 300, 301 and 303. Glycoluril resins are sold by Cytec Industries under trade names Cymel 1170, 1171, 1172, Powderlink 1174, and benzoguanamine resins are sold under the trade names of Cymel 1123 and 1125.

Photoresists for use in systems of the invention also may contain other materials. For example, other optional additives include actinic and contrast dyes, anti-striation agents, plasticizers, speed enhancers, etc. Such optional additives typically will be present in minor concentration in a photoresist composition except for fillers and dyes which may be present in relatively large concentrations such as, e.g., in amounts of from about 5 to 50 percent by weight of the total weight of a resist's dry components.

Various substituents and materials (including resins, small molecule compounds, acid generators, etc.) as being "optionally substituted" may be suitably substituted at one or more available positions by e.g. halogen (F, Cl, Br, I); nitro; hydroxy; amino; alkyl such as C1-8 alkyl; alkenyl such as C2-8 alkenyl; alkylamino such as C1-8 alkylamino; carbocyclic aryl such as phenyl, naphthyl, anthracenyl, etc; and the like.

*Lithographic processing*

In use, the underlying coating composition is applied as a coating layer to a substrate by any of a variety of methods such as spin coating. The coating composition in general is applied on a substrate with a dried layer thickness of e.g. between about 0.02 and 0.5 m, preferably a dried layer thickness of e.g. between about 0.04 and 0.20 m. The substrate is suitably any substrate used in processes involving photoresists. For example, the substrate can be silicon, silicon dioxide or aluminum-aluminum oxide microelectronic wafers. Gallium arsenide, silicon carbide, ceramic, quartz or copper substrates may also be employed. Substrates for liquid crystal display or other flat panel display applications are also suitably employed, for example glass substrates, indium tin oxide coated substrates and the like. Substrates for optical and optical-electronic devices (e.g. waveguides) also can be employed.

Preferably the applied coating layer is cured before a photoresist composition or other layer is applied over the composition. Cure conditions will vary with the components of the underlying composition. Particularly the cure temperature can depend on the specific acid or acid (thermal) generator that is employed in the coating composition (if an acid or acid generator is presenting the underlying coating composition). Typical cure conditions are from about 80°C to 225°C for about 0.5 to 40 minutes. Cure conditions preferably render the coating composition coating layer substantially insoluble to the organic composition solvent carrier (such as ethyl lactate and other photoresist solvents) as well as an alkaline aqueous developer solution.

After such curing, a photoresist or other composition (such as another organic composition) is applied above the surface of the top coating composition. For exemplary purposes, this overcoated layer is discussed as a photoresist layer. As with application of the bottom coating composition layer(s), the overcoated photoresist can be applied by any standard means such as by spinning, dipping, meniscus or roller coating. Following application, the photoresist coating layer is typically dried by heating to remove solvent preferably until the resist layer is tack free. Optimally, essentially no intermixing of the underlying composition layer and overcoated layer should occur.

The resist layer is then imaged with activating radiation through a mask in a conventional manner. The exposure energy is sufficient to effectively activate the photoactive component of the resist system to produce a patterned image in the resist coating layer. Typically, the exposure energy ranges from about 3 to 300 $mJ/cm^2$ and depending in part upon the exposure tool and the particular resist and resist processing that is employed. The exposed resist layer may be subjected to a post-exposure bake if desired to create or enhance solubility differences between exposed and unexposed regions of a coating layer. For example, negative acid-hardening photoresists typically require post-exposure heating to induce the acid-promoted crosslinking reaction, and many chemically amplified positive-acting resists require post-exposure heating to induce an acid-promoted deprotection reaction. Typically post-exposure bake conditions include temperatures of about 50°C or greater, more specifically a temperature in the range of from about 50°C to about 160°C.

The photoresist layer also may be exposed in an immersion lithography system, i.e. where the space between the exposure tool (particularly the projection lens) and the photoresist coated substrate is occupied by an immersion fluid, such as water or water mixed with one or more additives such as cesium sulfate which can provide a fluid of enhanced refractive index. Preferably the immersion fluid (e.g., water) has been treated to avoid bubbles, e.g. water can be degassed to avoid nanobubbles.

References herein to "immersion exposing" or other similar term indicates that exposure is conducted with such a fluid layer (e.g. water or water with additives) interposed between an exposure tool and the coated photoresist composition layer.

The exposed resist coating layer is then developed, preferably with an aqueous based developer such as an alkali exemplified by tetra butyl ammonium hydroxide, sodium hydroxide, potassium hydroxide, sodium carbonate, sodium bicarbonate, sodium silicate, sodium metasilicate, aqueous ammonia or the like. Alternatively, organic developers can be used. In general, development is in accordance with art recognized procedures. Following development, a final bake of an acid-hardening photoresist is often employed at temperatures of from about 100°C to about 150°C for several minutes to further cure the developed exposed coating layer areas.

The developed substrate may then be selectively processed on those substrate areas bared of photoresist, for example, chemically etching or plating substrate areas bared of photoresist in accordance with procedures well known in the art. Suitable etchants include a hydrofluoric acid etching solution and a plasma gas etch such as an oxygen plasma etch.

The following non-limiting examples are illustrative of the invention.

Examples 1-18 - Resin preparation

I. Resin preparation -- Procedure A

To a 250 mL three necked round bottom flask equipped with silicon oil temperature bath, condenser, magnetic stirrer, thermometer and nitrogen blanket was added the monomer mixture and tetrahydrofuran (THF) to a concentration

of 60 weight % monomers. The flask was then purged with nitrogen for ten minutes at room temperature. The reaction flask was lowered into the oil bath set temperature of 70 °C and the contents stirred for an additional ten minutes. The initiator V601 (DuPont Co.) was dissolved in 6 mL of THF and added to the reaction flask once the reaction solution had reached the desired temperature. After about 5 to 18hrs of reaction the product mixture was cooled to room temperature, diluted with THF to approximately about 30% solids and precipitated into hexanes spiked with isopropyl alcohol or into diispropyl ether depending on the polymer properties. The polymers were collected on a filter, washed and dried overnight under vacuum at 50 °C affording the respective polymers. The physical properties of the copolymers synthesized were analyzed by gel permeation chromatography (GPC), proton nuclear magnetic resonance ($1^{H}$-NMR), and differential scanning coulometry (DSC). The optical properties (n and k data) was obtained using the Woollam VUV-Vase instrument. The copolymer composition based on the mole percent monomer feed and their physical characteristics are presented in Table 1.

II. Resin preparation -- Procedure B

To a 300ml, 3 neck round bottom flask, fitted with a condenser and a nitrogen inlet was charged with Allyl alcohol and 45g THF. The contents were refluxed for 10 minutes under nitrogen. V601 was added to the reactor 10 minutes prior to the start of the monomer feed.

In a 200 ml amber glass bottle, the various monomers were suspended in 70g THF. Once a clear solution was obtained, the contents were transferred to the syringe fitted to a pump set at a flow rate of 20ml/hr. The monomers were fed into the reactor over a 5 hr time period. The contents were stirred for additional half hour and the reactor was then cooled to room temperature. Precipitation was carried out in Di-isopropyl ether. The white precipitates obtained were filtered and washed with Di-isopropyl ether (2 x100ml) and dried under vacuum overnight at 50°C.

The strip test results as set forth in Table 1 below demonstrate polymer insolubility to a typical resist solvent after a thermal treatment.

Polymers of Example 3 to 15 were each dissolved in ethyl lactate. To the solution tetramethoxymethyl glycoluril, Powderlink® 1174 (CYTEC Industries Inc.), was added at the indicated percent solid level and about 1 to 3 weight percent dodecylbenzene sulfonic acid with amine (King Industries) was added to form about 5 to 10 weight percent solutions. The solutions were spin coated onto 4 inch silicon wafer and baked for one minute at 215°C. One wafer of each was covered with a puddle of ethyl lactate for 60 seconds and then spun dry. Film thickness (FT) was measured after the bake and after the solvent exposure using a NANOSPEC 300 instrument. A passed result indicates complete film retention after solvent exposure.

The resulting copolymers composition and characteristics are shown in Table 1.

Table 1. Copolymer properties

| Example | Process | Composition | % Yield | Mw | Tg (°C) | x-linker | Strip test | n | k |
|---|---|---|---|---|---|---|---|---|---|
| 3 | A | AN/HVN (50/50) | 90 | 21k | 175 | None | Passed | 1.37 | 0.16 |
| 4 | A | AN/VN (50/50) | 90 | 10k | 127 | None | Failed | | |
| 5 | A | AN/Ac-Sty (50/50) | 80 | 15k | 110 | None | Failed | | |
| 6 | B | AN/t-BMA (50/50) | 66 | 7.5k | No Tg | None | 15% film loss | 1.64 | 0.07 |

The resulting terpolymer compositions and characteristics are shown in Table 2

Table 2

| Example | Process | Composition | % Yield | Mw | Tg (°C) | x-linker | Strip test | n | k |
|---|---|---|---|---|---|---|---|---|---|
| 7 | A | AN/NB/AA1 (50/35/15) | 60 | 3k | | 12% | Failed | | |
| 8 | A | AN/VAEE/AA1 (50/40/10) | 65 | 7k | | 12% | Failed | | |

(continued)

| Example | Process | Composition | % Yield | Mw | Tg (°C) | x-linker | Strip test | n | k |
|---|---|---|---|---|---|---|---|---|---|
| 9 | B | AN/AAI/Sty (35/35/10) | 70 | 9k | 87 | 8% | Passed | 1.65 | 0.75 |
| 10 | A | AN/AA1/Sty (45/35/20) | 66 | 11k | | 1% | Passed | 1.5 | 0.41 |
| 11 | A | AN/AAI/Sty (45/45/10) | 90 | 11k | | 1% | Passed | 1.65 | 0.34 |
| 12 | B | AN/AA1/Sty (50/45/5) | 66 | 4.2k | - | None | Passed | 1.7 | 0.28 |
| 13 | A | AN/HVN/Sty (50/45/5) | 66 | 22k | 179 | 1% | Passed | 1.4 | 0.214 |
| 14 | A | AN/HVN/Sty (50/40/10) | 90 | 21k | | 1% | Passed | | |
| 15 | A | ANBV-OH/Ac-Sty (50/5/45) | 75 | 16k | 104 | 12% | Passed | | |
| 16 | A | ANBV-OH/CHVE (50/5/45) | 70 | 7k | 45 | 12% | 15%FT loss | | |

The resulting tetrapolymer compositions and characteristics are shown in Table 3

Table 3

| | | | | | | | | | |
|---|---|---|---|---|---|---|---|---|---|
| 17 | B | AN/HVN/Sty/DHP (40/30/8/22) | 70 | 11k | | 3% | Passed | 1.47 | 0.27 |
| 18 | B | AN/HVN/Sty/AA1 (40/30/8/22) | 55 | 11k | | 3% | Passed | 1.6 | 0.25 |

Examples 19-22: Underlayer composition preparation and processing

The following outlines the procedure used to obtain relative sublimation data from the under layer compositions of the invention.

To determine the amount of material that sublimes from the film during the curing process, a test procedure was employed that measures the amount of material that condenses onto a quartz crystal placed approximately 1 cm above the polymer film during the process of curing the film on a bare silicon wafer using a hot plate. This is accomplished by measuring the change in frequency of the quartz crystal after curing the film and relating the difference in frequency to mass adsorbed through the following relationship:

$$\Delta F = \frac{2 \cdot Fo^2}{A \cdot \sqrt{\mu \cdot \rho}} \cdot \Delta m$$

$\Delta$ F = change in frequency
A = area of quartz crystal surface
Fo = frequency of crystal without adsorbate
$\mu$ = 2.947x$10^{10}$ kg ms
$\rho$ = specific gravity of adsorbate (assumed to be approximately 1.0)

The mass adsorbed is then converted to thickness and reported as Angstroms adsorbed.

Copolymers of Example 3, 12, and 17 were formulated into under layer compositions by adding sufficient cross-linker of tetramethoxymethy glycoluril, and thermal acid generator of dodecylbenzene sulfonic acid amine salt catalyst to achieve no film loss when exposed to a puddle of ethyl lactate solvent for 60 seconds. For this test, all films

were cured at 215°C for 60 seconds. The quartz crystal sublimation test results shown in Table 4 demonstrate that the under layer compositions of the invention have low degree of sublimation.

Table 4

| Example | Polymer of Example | Cross-linker Wt % | | Catalyst Wt % | | Film Thickness | Sublimation (Å) |
|---|---|---|---|---|---|---|---|
| 19 | 12 | 1 | | 0.1 | | 2000 Å | 3 |
| 20 | 17 | 2.5 | | 0.3 | | 2000 Å | 10 |
| 21 | 3 | none | | none | | 2000 Å | 3 |
| 22 | Commercial antireflective composition for 193 nm imaging | | | | | 800 Å | 16 |

Example 23 - Lithographic processing

A formulated coating composition of Example 19 is spin coated onto a silicon microchip wafer and cured at 175°C for 60 seconds on a vacuum hotplate to provide a dried coating layer.

A commercially available 193 nm photoresist is then spin-coated over the cured coating composition layer. The applied resist layer is soft-baked at 100°C for 60 seconds on a vacuum hotplate, exposed to patterned 193 nm radiation through a photomask, post-exposure baked at 110°C for 60 seconds and then developed with 0.26 N aqueous alkaline developer.

## Claims

**1.** A coated substrate comprising:

(a) an organic underlying coating composition layer comprising a resin that comprises nitrile groups and that is a reaction product of reagents comprising (1) acrylonitrile and/or methacrylonitrile and (2) hydroxyl vinyl naphthalene corresponding to the following structure:

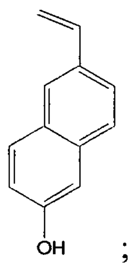
;

and
(b) one or more photoresist composition layers above the underlying coating composition layer.

**2.** The coated substrate of claim 1 wherein the resin comprises phenyl groups.

**3.** The coated substrate of any one of claims 1 through 2 wherein the underlying coating composition layer has been thermally treated.

**4.** The coated substrate of any one of claims 1 through 3 wherein at least two or three distinct photoresist composition layers are above the underlying coating composition layer.

**5.** A method of treating a microelectronic substrate, comprising:

applying an underlying coating composition of any one of claims 1 through 2 on the substrate; and
applying one or more photoresist composition layers above the underlying coating composition layer.

6. The method of claim 5 wherein the underlying coating composition is thermally treated prior to applying the one or more photoresist layers.

7. The method of claim 6 wherein the thermal treatment renders the underlying coating composition substantially insoluble to the solvent carrier of the subsequently applied one or more photoresist composition layers.

8. The method of any one of claims 5 through 7 further comprising imaging the one or more photoresist layers with radiation having a wavelength of below 200 nm.

9. The method of any one of claims 5 through 8 wherein the one or more photoresist layers are exposed in an immersion lithography process.

**Patentansprüche**

1. Ein beschichtetes Substrat, das Folgendes beinhaltet:

(a) eine organische Unterbeschichtungszusammensetzungsschicht, die ein Harz beinhaltet, das Nitrilgruppen beinhaltet und das ein Reaktionsprodukt von Reagenzien ist, die (1) Acrylonitril und/oder Methacrylonitril und (2) Hydroxylvinylnaphthalen, das der folgenden Struktur entspricht, beinhalten:

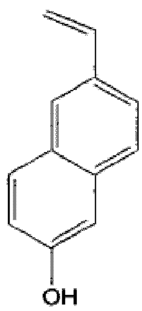
;

und
(b) eine oder mehr Fotolackzusammensetzungsschichten über der Unterbeschichtungszusammensetzungsschicht.

2. Beschichtetes Substrat gemäß Anspruch 1, wobei das Harz Phenylgruppen beinhaltet.

3. Beschichtetes Substrat gemäß einem der Ansprüche 1 bis 2, wobei die Unterbeschichtungszusammensetzungsschicht wärmebehandelt worden ist.

4. Beschichtetes Substrat gemäß einem der Ansprüche 1 bis 3, wobei sich mindestens zwei oder drei verschiedene Fotolackzusammensetzungsschichten über der Unterbeschichtungszusammensetzungsschicht befinden.

5. Ein Verfahren zum Behandeln eines mikroelektronischen Substrats, das Folgendes beinhaltet:

Aufbringen einer Unterbeschichtungszusammensetzung gemäß einem der Ansprüche 1 bis 2 auf das Substrat; und
Aufbringen einer oder mehr Fotolackzusammensetzungsschichten über der Unterbeschichtungszusammensetzungsschicht.

6. Verfahren gemäß Anspruch 5, wobei die Unterbeschichtungszusammensetzung vor dem Aufbringen der einen oder mehr Fotolackschichten wärmebehandelt wird.

7. Verfahren gemäß Anspruch 6, wobei die Wärmebehandlung die Unterbeschichtungszusammensetzung gegenüber dem Lösungsmittelträger der anschließend aufgebrachten einen oder mehr Fotolackschichten im Wesentlichen unlöslich macht.

8. Verfahren gemäß einem der Ansprüche 5 bis 7, das ferner das Bestrahlen der einen oder mehr Fotolackschichten mit Strahlung mit einer Wellenlänge von unter 200 nm beinhaltet.

9. Verfahren gemäß einem der Ansprüche 5 bis 8, wobei die eine oder mehr Fotolackschichten in einem Immersionslithografieprozess belichtet werden.

**Revendications**

1. Un substrat enduit, comprenant :

   (a) une couche de composition d'enduction sous-jacente organique comprenant une résine qui comprend des groupes nitrile et qui est un produit de la réaction de réactifs comprenant (1) l'acrylonitrile et/ou le méthacrylonitrile et (2) l'hydroxyl vinyl naphtalène correspondant à la structure suivante :

   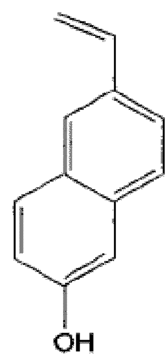

   ;

   et
   (b) une ou plusieurs couches de composition de réserve photosensible par-dessus la couche de composition d'enduction sous-jacente.

2. Le substrat enduit de la revendication 1 dans lequel la résine comprend des groupes phényle.

3. Le substrat enduit de l'une quelconque des revendications 1 à 2, dans lequel la couche de composition d'enduction sous-jacente a été soumise à un traitement thermique.

4. Le substrat enduit de l'une quelconque des revendications 1 à 3 dans lequel il y a au moins deux ou trois couches de composition de réserve photosensible distinctes par-dessus la couche de composition d'enduction sous-jacente.

5. Une méthode de traitement d'un substrat microélectronique, comprenant :

   le fait d'appliquer une composition d'enduction sous-jacente de l'une quelconque des revendications 1 à 2 sur le substrat ; et
   le fait d'appliquer une ou plusieurs couches de composition de réserve photosensible par-dessus la couche de composition d'enduction sous-jacente.

6. La méthode de la revendication 5 dans laquelle la composition d'enduction sous-jacente est soumise à un traitement thermique préalablement à l'application de ces une ou plusieurs couches de réserve photosensible.

7. La méthode de la revendication 6 dans laquelle le traitement thermique rend la composition d'enduction sous-jacente substantiellement insoluble par rapport au véhicule solvant des une ou plusieurs couches de composition de réserve photosensible appliquées par la suite.

8. La méthode de l'une quelconque des revendications 5 à 7 comprenant en outre le fait d'imager ces une ou plusieurs couches de réserve photosensible avec un rayonnement ayant une longueur d'onde inférieure à 200 nm.

9. La méthode de l’une quelconque des revendications 5 à 8 dans laquelle ces une ou plusieurs couches de réserve photosensible sont exposées dans un procédé de lithographie par immersion.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 0987600 A
- EP 0823661 A
- JP 2002014474 A
- US 20040191479 A
- EP 542008 A
- US 6261743 B
- US 4968581 A
- US 4883740 A
- US 4810613 A
- US 4491628 A
- US 5492793 A
- US 5929176 A
- US 6090526 A
- US 6042997 A
- US 5843624 A
- US 6048664 A
- US 6057083 A
- EP 01008913 A1
- EP 00930542 A1
- US 6048662 A
- US 0114914 W
- US 567634 A
- US 9921912 W
- EP 96118111 A
- EP 0783136 A
- EP 0164248 A
- EP 0232972 A
- US 5128232 A, Thackeray